Europäisches Patentamt

European Patent Office

Office européen des brevets

(11) Numéro de publication: **0 211 708**
**A1**

## DEMANDE DE BREVET EUROPEEN

(21) Numéro de dépôt: 86401396.6

(22) Date de dépôt: 25.06.86

(51) Int. Cl.⁴: **B 23 K 1/00**
**H 01 R 43/02**

(30) Priorité: 05.07.85 FR 8510329

(43) Date de publication de la demande:
25.02.87 Bulletin 87/9

(84) Etats contractants désignés:
AT BE CH DE GB IT LI LU NL SE

(71) Demandeur: BOUSSOIS S.A.
126-130 rue Jules Guesde
F-92302 Levallois-Perret(FR)

(72) Inventeur: Taupin, Pierre
10 Avenue du Colonel Schowller
F-59600 Maubeuge(FR)

(74) Mandataire: Bouju, André
Cabinet Bouju 38 avenue de la Grande Armée
F-75017 Paris(FR)

(54) **Procédé et dispositif de soudage d'une cosse sur un circuit électrique porté par une plaque de verre.**

(57) Selon l'invention on fixe une cosse (3) sur un circuit électrique (2) porté par une plaque de verre (1) en chauffant la soudure (6) au moyen d'une buse de chauffage (11) pour souffler un gaz chaud puis en refroidissant la soudure (6) au moyen d'une buse de refroidissement (12) pour souffler un gaz froid.

FIG.2

EP 0 211 708 A1

0211708

"Procédé et Dispositif de soudage d'une cosse sur un circuit électrique porté par une plaque de verre"

1

La présente invention concerne un procédé et un dispositif de soudage d'une cosse sur un circuit électrique porté par une plaque de verre, notamment un circuit chauffant d'une lunette arrière de véhicule automobile.

On connaît bien le principe de chauffage d'une plaque de verre par un circuit électrique résistif, notamment pour le dégivrage ou le désembuage de la lunette arrière d'un véhicule automobile. Dans la technique actuelle, le circuit électrique chauffant est généralement constitué par un émail conducteur à base d'argent déposé sur la surface du verre par sérigraphie. Afin de permettre l'alimentation du circuit, on fixe aux extrémités du circuit des cosses formées par des languettes en cuivre. La liaison entre la languette en cuivre et l'émail d'argent est obtenue par soudure avec apport d'un alliage métallique fondant à basse température. Cet alliage est généralement composé d'étain auquel d'autres métaux comme le plomb, l'indium, le cadmium, l'argent ont été ajoutés. La température à laquelle la soudure doit être effectuée varie suivant la nature de l'alliage mais elle est généralement comprise entre 120° C et 230° C.

Sur les lignes de montage automatisées, l'apport calorifique nécessaire à l'obtention de la température désirée est généralement réalisé par un chauffage par effet Joule de la cosse. Dans ce cas, deux électrodes électriques sont amenées au contact de la languette en cuivre en deux points espacés de celle-ci. Lorsque le contact est établi, une différence de potentiel électrique est appliquée entre les deux électrodes, ce qui provoque la circulation d'un courant électrique de forte intensité (quelques centaines d'ampères) dans le cuivre et son chauffage par effet Joule. L'expérience montre que l'énergie libérée, et donc la température obtenue, est liée aux résistances de contact existantes entre les électrodes d'amenée du courant et la languette de cuivre. L'expérience montre également qu'il est très difficile de maîtriser ces résistances de contact et que leur valeur ohmique est généralement aléatoire, les variations étant dues principalement à l'usure et l'encrassement des électrodes et aux variations de l'état de la languette en cuivre. La température de soudage n'est donc pas constante, ce qui entraîne inévitablement une dispersion des caractéristiques de la liaison obtenue et en particulier de la résistance mécanique.

En outre, avec ce mode de chauffage, toute l'énergie est dégagée dans les parties conductrices de l'électricité et la plaque de verre n'est chauffée que par conduction, ce qui entraîne des contraintes thermiques importantes au niveau de la liaison verre - métal. Il en résulte souvent des fissures dans le support en verre, ce qui est inacceptable compte tenu des exigences de qualité du produit final.

Le document GB-A-1 461 494 décrit un procédé et un dispositif pour la mise en oeuvre de ce procédé, pour sceller un composant électronique telle qu'une résistance dans un tube de verre ou de céramique dans lequel on utilise de l'air chaud pour chauffer de la soudure permettant de souder les bornes du composant sur une couche métallique disposée sur des régions de la paroi intérieure du tube. Il s'agit donc d'une application différente de celle de l'invention dans laquelle il n'est pas nécessaire d'obtenir une résistance à l'arrachement du composant qui soit particulièrement élevée.

Un but de la présente invention est de proposer un procédé de soudage permettant d'obtenir un cycle thermique bien adapté réduisant les contraintes dans le verre et assurant une régularité de la liaison entre la cosse et le circuit électrique déposé sur le verre.

En vue de la réalisation de ce but, on prévoit selon l'invention un procédé de soudage d'une cosse sur un circuit électrique porté par une plaque de verre, comportant les étapes de disposer de la soudure et une cosse au contact du circuit porté par la plaque de verre et de chauffer la soudure au-delà de son point de fusion, caractérisé en ce qu'on chauffe la soudure au moyen d'un gaz chaud soufflé sur la cosse et sur une partie de la plaque de verre adjacente à la cosse et en ce qu'après fusion de la soudure, on refroidit la cosse et la partie de plaque de verre adjacente au moyen d'un jet de gaz à une température inférieure à la température de fusion de la soudure.

Ainsi, l'apport de chaleur est aisément contrôlé par la température et le débit du gaz chaud et celui-ci assure un chauffage simultané de la cosse et du support en verre, réduisant ainsi les contraintes entre ces deux éléments. En outre, par le contrôle de la température et du débit du jet de gaz de refroidissement, on contrôle aisément la vitesse de refroidissement et on exerce donc un contrôle des contraintes auxquelles les différents éléments sont soumis.

L'étape de chauffage de la soudure suivie de l'étape de refroidissement permet également d'obtenir une très bonne résistance à l'arrachement de la cosse ainsi soudée.

Pour la mise en oeuvre du procédé selon l'invention, on prévoit un dispositif de soudage d'une cosse sur un circuit électrique porté par une plaque de verre comportant des moyens d'alimentation de soudure, des moyens d'alimentation et de positionnement d'une cosse sur une partie du circuit électrique, et des moyens de chauffage de la soudure, caractérisé en ce que les moyens de chauffage comportent une buse de chauffage pour souffler un gaz chaud, disposée de façon adjacente à la cosse et dirigée vers celle-ci et en ce que le dispositif comporte également une buse de refroidissement pour souffler un gaz de refroidissement, disposée de façon adjacente à la buse de chauffage. Ainsi, le jet de gaz chaud s'écoule non seulement sur la cosse mais également tout autour de celle-ci et provoque un échauffement simultané de la cosse et du support en verre, en même temps que la fusion de la soudure, disposée de façon adjacente à la buse de chauffage. En outre, le jet de gaz de refroidissement s'écoule d'une façon sensiblement analogue au jet de gaz de la buse de chauffage.

Selon un aspect préféré de l'invention, pour le soudage d'une cosse comportant un plan de symétrie, chaque buse de soufflage de gaz est disposée dans ce plan de symétrie. Ainsi, la cosse et la plaque de verre qui la supporte sont chauffées de façon symétrique et les contraintes sont donc régulièrement réparties.

D'autres caractéristiques et avantages de l'invention résulteront encore de la description ci-après d'un exemple non limitatif en référence aux dessins annexés parmi lesquels :

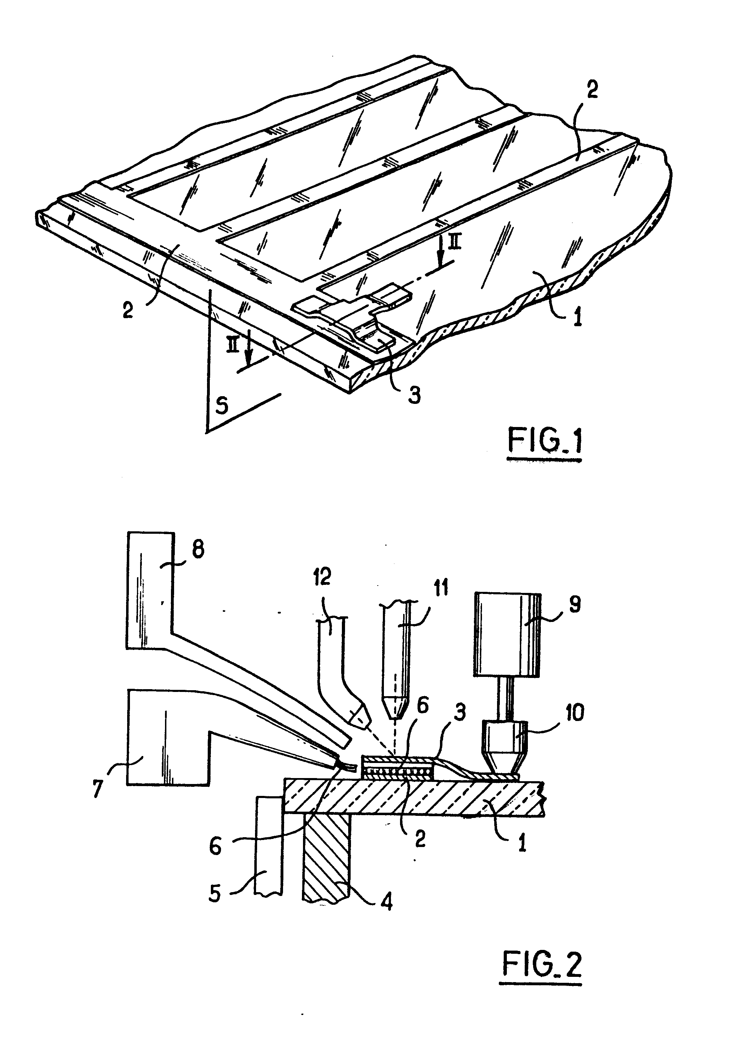

- la figure 1 est une vue en perspective partielle d'une plaque de verre portant un circuit électrique chauffant sur lequel est fixée une cosse ;

- la figure 2 est une vue en coupe selon le plan II-II de la figure 1 avec le dispositif de soudage représenté de façon schématique,

- la figure 3 est une représentation schématique d'un circuit d'alimentation en gaz chaud selon l'invention,

- la figure 4 est une représentation par des diagrammes des différentes opérations du soudage selon l'invention.

En référence aux figures, une plaque de verre 1 porte sur l'une de ses faces un circuit électrique résistif 2 obtenu par exemple par dépôt d'un émail d'argent par sérigraphie. Pour la liaison avec une alimentation électrique, une cosse 3 est fixée à une extrémité du circuit électrique 2.

Afin de réaliser le soudage de la cosse 3 sur le circuit électrique 2, la plaque de verre 1 équipée du circuit électrique 2 est mise en place sur la table 4 de la soudeuse et amenée contre des butées 5 servant à son positionnement. Un cordon de soudure 6 est avancé au-dessus de l'extrémité du circuit électrique 2 par un dispositif d'alimentation de soudure 7 et une cosse 3 est amenée par un dispositif d'alimentation de cosses 8. Le dispositif d'alimentation de soudure 7 et le dispositif d'alimentation de cosses 8 sont du type habituellement utilisé lors du soudage par chauffage électrique qui a été rappelé dans le préambule de la présente description et il n'est donc pas nécessaire d'en donner une description détaillée.

La cosse 3 est de préférence maintenue en place par un dispositif pneumatique 9 tel qu'un vérin, dont la tige 10 s'appuie sur une extrémité de la cosse 3 et maintient celle-ci plaquée contre la plaque de verre 1. Une buse de soufflage d'air chaud 11 est disposée à proximité de la cosse 3 et dirigée vers celle-ci. Dans le cas représenté où la cosse 3 présente un plan de symétrie S et a généralement une forme de T, la buse de chauffage 11 est de préférence disposée dans le plan de symétrie S et plus précisément à l'aplomb du milieu de la barre horizontale du T.

Selon le mode de réalisation préféré, le dispositif comporte également une buse de refroidissement 12 disposée de façon adjacente à la buse de chauffage 1 et, de préférence, également contenue dans le plan de symétrie S de la cosse 3 selon une inclinaison à 45° par rapport à la buse de chauffage et également dirigée vers le milieu de la barre horizontale du T.

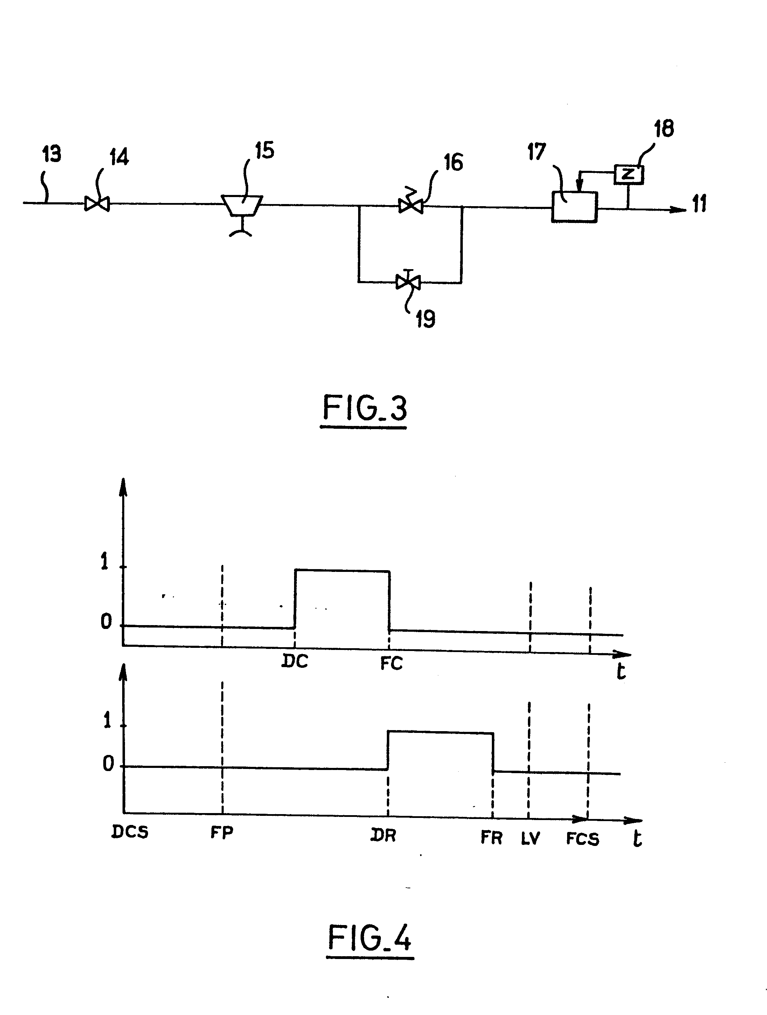

Pour l'alimentation en air chaud de la buse de chauffage 11, on prévoit avantageusement une installation représentée schématiquement sur la figure 3 et comprenant un conduit d'alimentation 13 en gaz froid, par exemple de l'air comprimé, une vanne de commande générale 14, un détendeur 15, une vanne de commande de débit 16, un dispositif de chauffage 17 et un régulateur de température 18. Afin d'éviter un régime transitoire dû à l'inertie thermique, en particulier pour les cycles de soudure courts, il est également avantageux d'installer une vanne de court-circuit 19 en parallèle à la vanne de commande 16 afin de maintenir la partie chaude à température constante même lorsque le cycle de chauffage est arrêté.

Le cycle d'opérations pour la fixation de la cosse est illustré par la figure 4 sur laquelle le diagramme du haut représente le débit de la buse de gaz chaud 11 en fonction du temps et le diagramme du bas représente le débit de la buse de refroidissement 12 en fonction du temps. Au début du cycle (DCS), les deux buses sont à l'état O, c'est-à-dire qu'aucun gaz ne s'en échappe. Après la fin du positionnement de la cosse (FF) la buse de gaz chaud est alimentée (DC) ce qui est représenté par le niveau 1, c'est-à-dire que du gaz chaud est envoyé vers la cosse à une température et selon un débit qui sont déterminés en fonction des caractéristiques de conductivité de la cosse 3 et de fusion de la soudure 6. Lorsque la fusion est obtenue, l'écoulement de gaz chaud est arrêtée (FC) et la buse de gaz froid est alimentée (DR). Après un temps de refroidissement, l'écoulement du gaz froid est arrêté (FR) et la tige 10 du vérin 9 est relevée (LV). A la fin du cycle de soudage (FCS) la plaque de verre est retirée du dispositif de soudage.

Bien que sur ces diagrammes on ait représenté au même instant l'arrêt de l'écoulement·du gaz chaud et le début de l'écoulement de gaz froid, l'expérience a montré qu'il était parfois avantageux d'ouvrir la vanne de refroidissement avant la fin du chauffage en particulier pour éviter la détérioration de l'isolant sur les cosses qui en sont munies.

On constate que le soudage selon l'invention est effectué sans contact mécanique entre les pièces à souder et le système thermique qui peut donc être entièrement statique. A titre d'exemple, le procédé selon l'invention a été testé par le soudage d'une cosse en cuivre d'une épaisseur de 0,8 mm en forme de T de 22x25 mm, sur une lunette arrière d'automobile en verre trempé de 3,1 mm d'épaisseur portant un réseau conducteur en émail d'argent. La soudure a été effectuée aux deux extrémités de la barre horizontale du T, ayant chacune une surface de 4 × 8 mm. La soudure utilisée contenait 70 % de plomb, 27 % d'étain, 3 % d'argent sous forme d'une plaque de 0,8 mm d'épaisseur avec emploi d'un flux décapant. La buse chaude était une buse cylindrique d'un diamètre de 4 mm en acier réfractaire placé à l'aplomb du milieu de la barre horizontale du T à 10 mm au-dessus de celui-ci. La buse froide était une buse cylindrique d'un diamètre de 4 mm en cuivre placée dans le plan de symétrie de la cosse à 15 mm de celle-ci et inclinée à 45° par rapport à la buse chaude. Le débit de gaz chaud pendant le chauffage, exprimé en mètres cubes normaux, c'est-à-dire ramené à la température ambiante, était de 2 m3/h pendant le chauffage et de 0,5 m3/h pendant le reste du cycle. La température de l'air chaud était de 600° C et le cycle de chauffage avait une durée de 5 secondes. Pour le refroidissement, de l'air à température ambiante a été alimenté selon un débit de 3 m3/h commençant à la fin du cycle de chauffage pendant une durée de 5 secondes. Les cosses ainsi soudées présentaient une résistance à l'arrachement supérieure à 150 Newton.

Bien entendu, les valeurs numériques exprimées ci-dessus ne sont pas critiques et peuvent varier en fonction des caractéristiques de la cosse et de la soudure. Bien que de l'air ait été utilisé, on peut également utiliser des gaz neutres, tels que de l'azote ou de l'argon pour éviter l'oxydation de la soudure et améliorer les performances.

Bien entendu, l'invention n'est pas limitée au mode de réalisation décrit ci-dessus et on peut y apporter des variantes d'exécution. En particulier, si cela est compatible avec les températures du gaz de chauffage et du gaz de refroidissement utilisé, on peut prévoir une seule buse avec un distributeur en amont de celle-ci, le distributeur assurant alternativement une liaison avec un circuit de gaz chaud et un circuit de gaz froid.

0211708

## REVENDICATIONS

1. Procédé de soudage d'une cosse (3) sur un circuit électrique (2) porté par une plaque de verre (1) comportant les étapes de disposer de la soudure (6) et une cosse (3) au contact du circuit porté par la plaque de verre (1) et de chauffer la soudure (6) au-delà de son point de fusion, caractérisé en ce qu'on chauffe la soudure (6) au moyen d'un gaz chaud soufflé sur la cosse (3) et sur une partie de la plaque de verre adjacente à la cosse et en ce qu'après fusion de la soudure (6), on refroidit la cosse (3) et la partie de plaque de verre adjacente au moyen d'un jet de gaz à une température inférieure à la température de fusion de la soudure.

2. Procédé de soudage de cosse conforme à la revendication 1, caractérisé en ce que le gaz de refroidissement est à la température ambiante.

3. Dispositif de soudage d'une cosse (3) sur un circuit électrique (2) porté par une plaque de verre (1) comportant des moyens d'alimentation de soudure (7), des moyens d'alimentation et de positionnement (8) d'une cosse (3) sur une partie du circuit électrique (2), et des moyens de chauffage de la soudure, caractérisé en ce que les moyens de chauffage comportent une buse de chauffage (11) pour souffler un gaz chaud, disposée de façon adjacente à la cosse (3) et dirigée vers celle-ci et en ce que ce dispositif comporte une buse de refroidissement (12) pour souffler un gaz de refroidissement, disposée de façon adjacente à la buse de chauffage.

4. Dispositif de soudage d'une cosse selon la revendication 3, pour le soudage d'une cosse comportant un plan de symétrie (S), caractérisé en ce que chaque buse de soufflage de gaz (11, 12) est disposée dans ce plan de symétrie (S).

5. Dispositif de soudage d'une cosse selon la revendication 4, pour le soudage d'une cosse (3) en forme de T, caractérisé en ce que la buse de chauffage (11) est disposée à l'aplomb du milieu de la barre horizontale du T.

6. Dispositif de soudage d'une cosse selon la revendication 5, caractérisé en ce que la buse de refroidissement (12) est inclinée à 45° par rapport à la buse de chauffage (11) et dirigée vers le milieu de la barre horizontale du T.

1 / 2

0211708

FIG.1

FIG.2

0211708

FIG.3

FIG.4

## DOCUMENTS CONSIDERES COMME PERTINENTS

| Catégorie | Citation du document avec indication en cas de besoin des parties pertinentes | Revendication concernée | CLASSEMENT DE LA DEMANDE (Int Cl 4) |
|---|---|---|---|
| Y | GB-A-1 461 494 (ASAHI GLASS CO. LTD.)<br>* Page 1, lignes 9-16; page 1, ligne 85 - page 2, ligne 14; page 2, ligne 61 - page 3, ligne 75; figures 1-4 * | 1-3 | B 23 K 1/00<br>H 01 R 43/02 |
| Y | FR-A-2 073 856 (N.V. PHILIPS' GLOEILAMPENFABRIEKEN)<br>* En entier * | 1-3 | |
| A | US-A-3 653 572 (S.Z. DUSHKES et al.)<br>* Colonne 2, lignes 3-72; figures 1,2 * | 1,3,4 | |
| A | GB-A-2 137 130 (GLAVERBEL)<br>* Page 3, ligne 102 - page 4, ligne 31; figures 4,5,7 * | 1,3,5 | **DOMAINES TECHNIQUES RECHERCHES (Int Cl 4)**<br><br>B 23 K<br>H 01 R<br>H 05 B |

Le present rapport de recherche a été établi pour toutes les revendications

| Lieu de la recherche | Date d'achevement de la recherche | Examinateur |
|---|---|---|
| LA HAYE | 10-10-1986 | ARAN D.D. |